# EUROPEAN PATENT APPLICATION

(11) **EP 3 621 187 A1**
(43) Date of publication of application: **11.03.2020**
(21) Application number: 19156660.3
(22) Date of filing: 12.02.2019
(51) Int. Cl.: H02K 35/02, H01L 41/113, H02N 2/18

(54) **HYBRID ENERGY HARVESTING UNIT AND USE HEREOF**

(71) Applicant: Ventus Engineering GmbH, 1030 Wien (AT)
(72) Inventor: LÜBKER, Poul Anker Skaarup, 6340 Baar (CH); MINGALIEV, Shavkat, 1010 Wien (AT); SCHNEIDER, Michael, 1190 Wien (AT); SCHMID, Ulrich, 1140 Wien (AT); SCHLÖGL, Matthias, 1140 Wien (AT)
(74) Representative: Tellefsen, Jens J.

(57) **Abstract**

The present invention relates to a hybrid energy harvesting unit (1) configured to harvest energy when being attached to an object (2) in motion. The hybrid energy harvesting unit (1) may be configured to be attached to the object (2) at a point of contact (4). The hybrid energy harvesting unit (1) may comprise one or more coils (10), a piezoelectric element (40) with a magnetic mass (48) and a permanent magnet (50). The invention relates to a hybrid energy harvesting unit (1) with high durability for continuously supplying low power consuming devices with energy. The invention relates to a hybrid energy harvesting unit (1) transforming potential energy, due to gravitation, into electrical energy.

## Description

### Field of the Invention

The present invention relates to a hybrid energy harvesting unit configured to harvest energy when being attached to an object in motion. The hybrid energy harvesting unit may be configured to be attached to the object at a point of contact. The hybrid energy harvesting unit may comprise one or more coils, a piezoelectric element with a magnetic mass and a permanent magnet. The invention relates to a hybrid energy harvesting unit with high durability for continuously supplying low power consuming devices with energy. The invention relates to a hybrid energy harvesting unit transforming potential energy, due to gravitation, into electrical energy.

### Background of the Invention

Sensors are widely used for condition monitoring of working units. The sensors may measure physical loads, such as vibration, strain and temperature, which may cause stress on a working unit when it is continuously exposed to such loads, especially, when the loads exceed threshold values.

The sensors should in many cases preferably be placed in the most exposed areas of the working unit. However, placing sensors in such areas may pose challenges, such as restricted access to placing the sensor and limited access for servicing and maintaining such sensor during the lifespan of the working unit in which the sensor is to be installed.

This may bring additional challenges, such as providing lasting power supply for the sensor in such restricted access areas. Cabling may expose challenges as these may add weight to the construction of the working unit. A working unit may be constructed with a balanced weight distribution for an optimal operation of the working unit, why subsequent added weight may be undesirable. Other reasons why cabling is very difficult, or even impossible, may be the actual construction of the working unit per se or how single parts of the working unit move relative to each other or interact when in use. Additional reasons may be security and legal considerations if the working unit is exposed to lightning, large temperature variations or other harsh conditions which may cause power failures in such cabling.

Battery-powered sensors may be an option where cabling is not a preferred option or an option at all. However, with a life-time of a working construction, which may be years or even decades, and a sensor with a power-consumption in the milliwatt (mW) range, the battery lifetime will be relatively short and hence, a sensor which needs service in relative short intervals. Servicing battery powered equipment where batteries have to be recharged or changed can therefore be very costly, both related to manpower and certainly also considering lost production.

With current battery technology, an increase in energy storage generally results in increased physical size and weight of the battery and/or a significant increase in costs for the battery. The physical size and weight of the battery or other powering devices may pose a challenge in regard to the construction of the working unit both in regard to actual space for such a battery and also in regard to weight distribution and balancing this weight in the construction for an optimal operation of the working unit.

Another challenge using battery-powered supply is changing temperatures, i.e. constantly high or low temperatures during operation. This can lead to less battery capacity and may even damage the batteries.

Another alternative to cabled power supply may be the use of renewable energy sources, such as sun or wind power. However, the requirement that the energy harnessing elements needs to be exposed to wind and/or sun may be a challenge in working units and especially when operating in harsh conditions.

The implementation of other power-consuming units than sensors in working constructions may be envisioned to bring the same challenges. Such units could encompass transmitters, transponders, receivers or similar units.

### Object of the Invention

It is an object of this invention to overcome one or more of the short-comings of the prior art. One specific object is to provide a hybrid energy harvesting unit with high durability to continuously supply small devices with energy. Another specific object is to transform potential energy, due to gravitation, to electrical energy.

### Description of the Invention

The aforementioned aspects may be achieved by a hybrid energy harvesting unit configured to harvest energy when being attached to an object in motion. The hybrid energy harvesting unit may be configured to be attached to the object at a point of contact. The hybrid energy harvesting unit may comprise one or more coils with a coil length. The one or more coils may be arranged along a guiding structure adapted to provide a constrained trajectory. Each coil may encircle a part of the provided constrained trajectory.

The hybrid energy harvesting unit may further comprise a piezoelectric element arranged in a cantilever structure. The piezoelectric element may comprise an anchoring end and a cantilever tip. The piezoelectric element may comprise a magnetic mass arranged at the cantilever tip.

The hybrid energy harvesting unit may comprise a permanent magnet with a permanent magnet length arranged in the guiding structure. The permanent magnet may be adapted to move relative to the guiding structure along the provided constrained trajectory.

The anchoring end and the guiding structure may be adapted to be attached to the object separated by a distance, within which distance the permanent magnet, when moved relative to a part of the guiding structure, may interact with the magnetic mass to deform the piezoelectric element.

In an alternative embodiment, the hybrid energy harvesting unit may comprise one or more coils with a coil length arranged along a guiding structure. The guiding structure may be adapted to provide a constrained trajectory. Each coil may encircle a part of the provided constrained trajectory. The hybrid energy harvesting unit may further comprise a piezoelectric element arranged in a cantilever structure with an anchoring end and a cantilever tip. A magnetic mass may be arranged at the cantilever tip.

The hybrid energy harvesting unit may further comprise a permanent magnet with a permanent magnet length arranged in the guiding structure. The permanent magnet may be adapted to move along the provided constrained trajectory.

The hybrid energy harvesting unit may be adapted to be attached to the object with the anchoring end and the guiding structure arranged relative to the point of contact. The constrained trajectory may be arranged within a distance of the magnetic mass, within which distance the permanent magnet when moved along a part of the provided constrained trajectory interacts with the magnetic mass to deform the piezoelectric element.

The above use of encircle may be in the meaning of surround.

The object in motion may be a part of a working unit, where the part of the working unit rotates, sways, rolls and/or rocks relative to a geo-fixed point. In the following, when referring to a static position and a shift in position, these are positions and shifts as seen from the geo-fixed point. In this case, a shift in position may refer to relocation and/or rotation.

The piezoelectric element may comprise a substrate layer, a piezoelectric layer and two electrodes arranged in a cantilever structure. The cantilever structure may form an elongated structure with an anchoring end and a cantilever tip. The piezoelectric element may be configured to generate electricity when mechanically deformed. The structure of the piezoelectric element may be such that when deformed and released it has an oscillating structure. The elongated structure may define the oscillating plane.

The substrate layer of the piezoelectric element may be made of materials with a very high yield force, e.g. silicon, brass or spring-steel. For the piezoelectric layers, all piezoelectric materials can in general be used. For improved usability, materials with a high piezoelectric coefficient, a low dielectric constant, and a low loss factor may be chosen. Useable materials may include PZT (lead zirconate titanate), A1N (aluminium nitride), doped AlN, ZNO (zinc oxide), PVDF (Polyvinylidenfluorid) or comparable materials or material compositions. These are examples and a non-exhaustive list of useable materials and should be read as such.

The magnetic mass arranged at the cantilever tip causes excitation of the cantilever structure when arranged in a magnetic field attracting or repelling the magnetic mass such that the piezoelectric element is deformed. The weight of the magnetic mass, the length and the stiffness of the structure are all parameters which may influence the frequency of the oscillation of the piezoelectric element.

The permanent magnet may be made of typical magnetisable materials. This could for example be NdFeB, ferrit, Sm(Co,Fe,Cu,Zr) or comparable materials or material compositions. These are examples and a non-exhaustive list of useable materials and should be read as such.

The guiding structure may be made of non-Ferro-magnetic material. This may reduce the friction between the permanent magnet and the guiding structure PM or the friction reducing suspension and the guiding structure. The non-Ferro-magnetic material may be PTFE or comparable materials.

The magnetic mass may be made of typical magnetisable materials. This could for example be NdFeB, ferrit, Sm(Co,Fe,Cu,Zr) or comparable materials or material compositions. These are examples and a non-exhaustive list of useable materials and should be read as such.

In one aspect, the guiding structure may be a tube enclosing the permanent magnet and the constrained trajectory.

In one aspect, the guiding structure may be a rail wherein the permanent magnet runs and where the rail defines the constrained trajectory. The rail may be an open structure, such that the permanent magnet is not isolated from the surroundings as in the case of a tube. Alternatively, the guiding structure may be a bar and the permanent magnet having a through-going hole in the direction of the trajectory and is guided by being suspended on the bar via this through-going hole.

In one aspect, the guiding structure may be a circular or partly circular structure. In another aspect, the guiding structure may be a linear structure.

The shape of the guiding structure may include shapes with or without endpoints. For example a guiding structure shaped as a circle does not have any endpoints, a guiding structure with a linear shape has endpoints, a partly circular shaped structure may have endpoints or not, as partly circular may refer to only a single section of the structure being curved. Alternatively, partly circular may refer to a guiding structure with a combination of multiple curved or arched sections and/or linear sections.

The hybrid energy harvesting unit may be used in different modes. In one mode, the permanent magnet may be held in a static position by the gravitational force and the guiding structure, and the guiding structure and the piezoelectric element move relative hereto. This may for example be in the case where the guiding structure is a circular guiding structure and where the guiding structure is attached to the moving objects, such that the guiding structure rotates around its centre point in the plane comprising the provided trajectory. In this mode both the guiding structure and the piezoelectric element are moved with the moving object to which they are attached.

For understanding the dynamics of the hybrid energy harvesting unit, it may be compared to a rotor/stator system. For this mode, using this comparison, the permanent magnet may be referred to as the stator and the guiding structure and the piezoelectric element as the rotor.

In another mode, the guiding structure and the piezoelectric element may be the static element in the sense that the permanent magnet moves relative to these elements. The permanent magnet may be shifted in position due to the influence of gravitational force (f_G) and any rotational induced forces (f_CF) caused by the motion of the object to which the hybrid energy harvesting unit is attached.

This may for example be in the case where the guiding structure has a shape and/or is attached to the moving object such that the permanent magnet is shifted in position by the gravitational force (f_G), a rotation of the confined trajectory, and/or a motion force induced by the motion of the object. This may be a non-circular guiding structure arranged with the centre point independent of a rotational centre point of the object. Alternatively, it may be a circular guiding structure being arranged away from a possible rotational centre point of an object. In both cases, the motion of the guiding structure may be in the plane of the provided trajectory such that the permanent magnet may be shifted in position. In this mode, the guiding structure, the piezoelectric element, and the permanent magnet may be shifted in position.

For understanding the dynamics of the hybrid energy harvesting unit, it may be compared to a rotor/stator system. The guiding structure may be arranged such that the provided constrained trajectory is in a plane non-perpendicularly to a gravitational force vector (f_G). The hybrid energy harvesting unit may furthermore be impacted with a rotational force from the object to which it may be attached.

The permanent magnet may move relative to the guiding structure and the piezoelectric element. The permanent magnet may shift position as a consequence of a change in position or movement of the moving object. The shift in position of the permanent magnet may depend on the provided trajectory and the forces impacting the permanent magnet including gravitational force (f_G), centrifugal forces (f_CF) caused by the rotational movement of the moving object and/or the force impacted on the permanent magnet from the guiding structure.

One effect of the hybrid energy harvesting unit is that it transforms potential energy, due to gravitational force and kinetic energy transmitted from the motion of the object, into electrical energy. The electrical energy is obtained from the motion of the permanent magnet through the coils and from the interaction of the permanent magnet with the magnetic mass of the piezoelectric element resulting in a deformation and subsequent oscillation of the piezoelectric element.

When the permanent magnet passes through a coil, an electrical voltage may be induced, and when the piezoelectric element oscillates, and hence is continuously deformed, an electric current may be generated due to the piezoelectric effect.

Generated polarization charges in the piezoelectric elements may generally be modeled as electric current.

An important factor in the excitation process is the speed of the PM, which can be optimized by e.g. weight, angular mounting position, distance from the centre of rotation or RPM of the object.

The hybrid energy harvesting unit may be used to power a wireless power consuming unit, such as for example a sensor, a transmitter, receiver, transponder, or comparable units. The sensors may be used to measure physical quantities, such as vibration, strain, temperature to mention a few examples.

One advantage of the hybrid energy harvesting unit is that it may be arranged close to the power consuming unit thereby achieving a self-powered unit eliminating the need for cabling to a central supply unit. There will still be need for connecting the hybrid energy harvesting unit to the power consuming unit(s), however this is not what is referred to in connection with cabling. Cabling refers to power cables to a central supply unit, such as for example a power plant, generators or other central power supply units.

Another advantage may be achieving to eliminate the need for "large" energy storage units located close to the power consuming unit, as for example batteries, which may typically be needed for battery-only powered units.

Cabling may pose difficulties within working units comprising moveable parts, which moveable parts may especially be the parts of interest for monitoring. Cabling may add weight to the construction of the working unit, which construction may be carefully designed for achieving a balanced construction for an optimal operation. Furthermore, cabling may be a challenge in working units where the single parts move relative to each other or otherwise interact when in use. Other reasons may be security and legal considerations in case the working unit is exposed to lightning, large temperature variations or other harsh conditions which may cause power failures in such cabling.

Yet a further effect of the energy hybrid harvesting unit may be to provide a lasting power supply. This may be advantageous in regard to installing power-consuming units in areas with restricted accessibility. In such cases, the hybrid energy hybrid harvesting unit may be installed as a power supply, eliminating or reducing the requirement for service and maintenance in regard to change of batteries. Especially when the lifetime of a working construction is years or even decades, the hybrid energy harvesting unit may be advantageous over a battery as the sole power source, because a sensor with a power-consumption in the mW-range will require several recharges or replacements over the lifetime of the working unit with current battery technology.

Furthermore, the hybrid energy harvesting unit may be incorporated in the construction of the moving object or alternatively be an add-on for subsequent implementation.

In one embodiment of the hybrid energy harvesting unit, the one or more coils arranged along one guiding structure may have coil lengths which are substantially equal to the permanent magnet length of the permanent magnet comprised in the guiding structure.

Several coils may enclose the trajectory of each permanent magnet. When the permanent magnet passes through a coil, an electrical voltage can be induced. To optimize the generated power, the dimensions of the permanent magnet and the dimensions of the coil have to be carefully matched.

In one embodiment of the hybrid energy harvesting unit, the permanent magnet has a magnetic field being higher or equal to the magnetic field of the one or more magnetic masses it interacts with.

The optimal speed of the magnet in the guiding structure when passing a piezoelectric element is important for achieving an optimal deformation of the element and thereby optimizing the resulting generated power from subsequent oscillation behaviour of the piezoelectric element.

The optimal speed of the magnet in the guiding structure can be tuned by choosing the correct mounting distance and angle related to the centre of rotation. Furthermore, the magnetic field of the permanent magnet should be maximized.

It is important that the magnetization or the magnetic field strength of the permanent magnet and the magnetic proof mass of the cantilever as well as the distance between the piezoelectric element and the guiding structure is tuned in a way, such that the excitation of the piezoelectric element is optimal in terms of power generation and wear.

In case two or more guiding structures are arranged to harvest power in parallel, then they should be arranged in a way where voltage is generated in synchronized phases to maximize power harvesting.

In one embodiment of the hybrid energy harvesting unit, the permanent magnet and/or the guiding structure comprise(s) friction reducing suspension for the moveable permanent magnet.

One effect of the friction reducing suspension may be to reduce wear and tear on the permanent magnet and the guiding structure. This may be advantageous in regard to achieving an increased lifetime of the hybrid energy harvesting unit, but also to obtain uniform operation of the hybrid energy harvesting unit over time regardless of changing conditions, e.g. temperature.

Another effect of the friction reducing suspension may be to reduce the frictional resistance between the guiding structure and the permanent magnet such that the permanent magnet may be set in motion in the guiding structure more easily by gravitational force, f_G. Due to the fact that the centrifugal force f_CF gets larger the further from the rotational centre the hybrid energy harvesting unit is placed, the frictional resistance and the centrifugal force, f_CF, may exceed the gravitational force, f_G, and thereby prevent the movement of the permanent magnet in the guiding structure. The friction reducing suspension may therefore be advantageous in regard to achieving a wider operation range of the hybrid energy harvesting unit in terms of distance requirements for its installation.

In one embodiment of the hybrid energy harvesting unit, the cantilever structure of the piezoelectric element may comprise a substrate layer, a bottom electrode layer, a piezoelectric layer and a top electrode layer. The layers may be arranged in a sandwich structure. The sandwich structure may reach from the anchoring end to the cantilever tip. The piezoelectric layer may be arranged between the top electrode layer and the bottom electrode layer.

The piezoelectric layer may act as a transducer to convert mechanical energy into electrical energy. By compressing or stretching the piezoelectric material, polarisation charges may be formed on the surface of the piezoelectric layer. The polarisation charges results in a current being transmitted by the top and/or bottom electrode layers.

In one embodiment, the hybrid energy harvesting unit may comprise multiple piezoelectric elements in an array. The anchoring end of each piezoelectric element may be adapted to be attached to the object at a distance, within which distance the permanent magnet, when moved relative to a part of the guiding structure, interacts with the magnetic mass to deform the piezoelectric element.

In an alternative embodiment of the hybrid energy harvesting unit with an array of piezoelectric elements, the hybrid energy harvesting unit may be adapted to be attached to the object with the anchoring end of each piezoelectric element arranged relative to the point of contact. For each piezoelectric element, the constrained trajectory may be arranged relative to the magnetic mass within a distance, within which distance the permanent magnet, when moved along a part of the provided constrained trajectory, interacts with the magnetic mass to deform the piezoelectric element.

The array of piezoelectric elements may consist of several cantilever structures comprising a substrate layer and a piezoelectric layer in between two electrodes.

The piezoelectric elements in the array may be coupled by a single-substrate manufacturing process, a rigid mounting structure, magnetically or in comparable ways. The piezoelectric elements may be coupled such that their oscillations can be synchronized. By synchronizing the oscillations, the phases may be shifted to generate a more uniform power generation over time to optimize the power harvesting.

In one embodiment, the hybrid energy harvesting unit comprising a guiding structure with a first closed end and a second closed end may further comprise a stopper permanent magnet in one or both closed ends.

One effect of this embodiment may be to reduce wear and tear of the permanent magnet and the guiding structure. The stopper permanent magnet poled opposite to the moving permanent magnet in the guiding structure is mounted in the closed end of the guiding structure. As the moving permanent magnet approaches the stopper permanent magnet, the opposing magnetic fields slow down the movement of permanent magnet until it stops, without touching the closed end of the guiding structure.

In one embodiment, the hybrid energy harvesting unit comprising a guiding structure with a first closed end and a second closed end further comprising a stopper permanent magnet in one or both closed ends, the hybrid energy harvesting unit may further comprises a suspension arrangement in either of the closed ends. The suspension arrangement may comprise a fixed coil and a deformable suspension. The deformable suspension may have a compressed length and an elongated length. The suspension arrangement may be adapted to be arranged with one end of the deformable suspension and one end of the fixed coil fixed to the object. The fixed coil may be adapted to be arranged to encircle the stopper permanent magnet or a part hereof at a length of the deformable suspension being within the range between the compressed length and the elongated length.

Another effect of this embodiment may be that the suspension arrangement may create a further electromagnetic energy harvester part to the hybrid energy harvesting unit. The magnetic counter acting force of the moving permanent magnet acting on the stopper permanent magnet may not only slow down the permanent magnet, but may, due to the deformable suspension, result in a counteracting force on the stopper permanent magnet, which may result in that the entire guiding structure reacts to this impact with an oscillation in its own sinusoidal resonant frequency. This oscillation may cause the stopper permanent magnet to oscillate through the fixed coil in the suspension arrangement and thereby generate an electrical voltage. Inducing an oscillation of the guiding structure will result in generation of electrical voltage by both suspension arrangements.

In one embodiment the hybrid energy harvesting unit may comprise an interconnecting and a rectifier circuit.

Considering that all three energy harvester parts (the piezoelectric element, the 'permanent magnet - coil' interaction, and the 'stopper permanent magnet - fixed coil' interaction)have different resonant frequencies and all of them are out of phase, they may be connected by means of a special interconnecting and rectifying circuit to achieve a DC supply.

In case two or more guiding structures are arranged to harvest power in parallel, they may be arranged in a way such that voltage is generated in synchronized phases. To maximize power harvesting, the rectifying circuit to be used may comprise one or more rectifying elements, e.g. one rectifying element on module level or one rectifying element per harvesting device.

In one embodiment, the hybrid energy harvesting unit may comprise a power management circuit and rechargeable energy storage.

Each individual coil and each individual piezoelectric element may be connected individually to the power management unit. In the case of energy harvester parts comprising multiple coils and/or multiple piezoelectric elements, a switch function may be needed to manage from which coil or piezoelectric element electrical power is generated and is to be collected.

The power management module may comprise one or more ac/dc converters.

The rechargeable energy storage may be integrated as a battery or a capacitor. The energy storage may be used to power one or more power consuming units continuously. The power consuming units may be sensor units.

The hybrid energy harvesting unit is based on an impact energy conversion, which may result in a slowly decaying energy production following the individual impacts.

The rechargeable energy storage may therefore have the effect of achieving a constant power supply.

Another effect of this embodiment is that the hybrid energy harvesting unit may generate a surplus of energy and hence store excess energy to power the power consuming unit during idling or downtime of the working unit to which the hybrid energy harvesting unit is attached.

One objective of the invention may be achieved by a method for harvesting energy from an object in motion comprising an act of displacing a permanent magnet through one or more coils along a guiding structure. The method may further comprise an act of arranging a piezoelectric element with a cantilever structure, an anchoring end and a cantilever tip with a magnetic mass with a distance to the guiding structure, within which distance the permanent magnet, when moved relative to at a part of the guiding structure, may interact with the magnetic mass to deform the piezoelectric element.

The effects and advantages of this embodiment may be in line with those previously described for the hybrid energy harvesting unit.

Especially, as for the hybrid energy harvesting unit, the effect of the method for harvesting energy is that potential energy, due to gravitational force and kinetic energy transmitted from the motion of the object, may be transformed into electrical energy. The electrical energy may be obtained from the motion of the permanent magnet through the coils and from the interaction of the permanent magnet with the magnetic mass of the piezoelectric element resulting in a deformation and subsequent oscillation of the piezoelectric element.

When the permanent magnet passes through a coil, an electrical voltage may be induced and when the piezoelectric element oscillates, and hence is continuously deformed, an electric current may be generated due to the piezoelectric effect.

One objective of the invention may be achieved by using the hybrid energy harvesting unit attached to a rotational moveable part.

The effects and advantages of this embodiment may be in line with those previously described for the hybrid energy harvesting unit.

In one embodiment of the use of the hybrid energy harvesting unit, the rotational moveable part may be comprised in a wind turbine.

One effect of this embodiment may be that the hybrid energy harvesting unit may be used to power a wireless energy autonomous node in rotor blades of wind power plants, e.g. one or more sensors. The hybrid energy harvesting unit may be arranged in the rotor and/or in the blades. The hybrid energy harvesting unit may be arranged in the interior or on the exterior of the parts. Alternatively, the hybrid energy harvesting unit may be integrated in the parts at fabrication. Due to the changing force distributions in the rotor blades during operation, the hybrid energy harvesting unit may be dimensioned and arranged such that the energy generation is independent of the mounting point and rotational position of the rotor blade.

To induce the movement of the permanent magnet, the changing gravitational force vector, F_G, in the rotor blade is used. The constrained trajectory of the magnet is in the plane aligned perpendicularly to the vector of the centrifugal force (F_CF) created through the rotational movement of the rotor blade to avoid sticking of the PM due to the before-mentioned forces.

Correct location and orientation for installation is important to reach the necessary and optimal speed for movement of the permanent magnet in the guiding structure. Therefore, at least the following could be taking into consideration:
- distance from the centre of rotation
- RPM of the rotating unit in different operational modes (Rotor RPM behaviour and wind regime/wind distribution on actual location)
- angle of the tube related to the rotational movement (stall regulated / semi pitch regulated / pitch regulated rotors).

One advantage of the hybrid energy harvesting unit may be in a case where a sensor or another power-consuming unit is operated inside a rotor blade or a comparable location where there is no light or wind which could be used as a renewable energy source. In this case the hybrid energy harvesting unit may still act as a renewable energy source due to the effect of transforming potential energy, due to gravitation, to electrical energy using electromagnetic and piezoelectric harvesting elements.

One objective of the invention may be achieved by using the hybrid energy harvesting unit embedded in a power consuming unit.

One effect of this embodiment may be that a self-powered unit having a wireless/autonomous sensor unit is achieved.

The effects and advantages of this embodiment may be in line with those previously described for the hybrid energy harvesting unit in connection with a power consuming unit. Especially advantageous may be the reduced need for cabling, and especially power cabling, and the reduced maintenance and service tasks for power consuming units to be located in areas with limited accessibility.

The hybrid energy harvesting unit and the power consuming unit(s) may be connected using cables, however this is not what is referred to in connection with cabling. Cabling in the above refers to power cables to a central supply unit, such as for example a power plant, generators or other central power supply units.

### Description of the Drawing

Embodiments of the invention will be described in the figures, whereon:
Fig. 1 illustrates one embodiment of the elements of the hybrid energy harvesting unit.
Fig. 2 illustrates one embodiment of the arrangement of the elements of the hybrid energy harvesting unit.
Fig. 3 illustrates one embodiment of the hybrid energy harvesting unit with an array of piezoelectric elements.
Fig. 4 illustrates two embodiments of the hybrid energy harvesting unit with a circular guiding structure.
Fig. 5 illustrates two embodiments of the hybrid energy harvesting unit.
Fig. 6 illustrates one embodiment of the hybrid energy harvesting unit in operation.
Fig. 7 illustrates another embodiment of the hybrid energy harvesting unit in operation.
Fig. 8 illustrates an embodiment of the hybrid energy harvesting unit with suspension arrangements.
Fig. 9 illustrates the use of the hybrid energy harvesting unit with a power consuming unit.
Fig. 10 illustrates the use of the hybrid energy harvesting unit attached to a wind turbine blade.

### Detailed Description of the Invention

- Item: No.
- 1: Hybrid energy harvesting unit
- 2: Object
- 4: Point of contact
- 10: Coil
- 11: Coil length
- 12: Fixed coil
- 20: Guiding structure
- 22: Circular structure
- 24: Linear structure
- 24A: First closed end
- 24B: Second closed end
- 30: Constrained trajectory
- 32: Circular trajectory
- 34: Linear trajectory
- 40: Piezoelectric element
- 42: Cantilever structure
- 44: Anchoring end
- 46: Cantilever tip
- 48: Magnetic mass
- 49: Array of piezoelectric elements
- 50: Permanent magnet
- 51: Permanent magnet length
- 52: Friction reducing suspension
- 60: Tube
- 70: Distance
- 80: Suspension arrangement
- 82: Deformable suspension
- 84: Stopper permanent magnet
- 86: Compressed length
- 88: Elongated length
- 90: Rectifier circuit
- 91: Interconnecting circuit
- 92: Power management circuit
- 94: Rechargeable energy storage
- 100: Use
- 110: Wind turbine
- 112: Rotational moveable part of a wind turbine
- 114: Power consuming unit
- 141: Top electrode layer
- 142: Bottom electrode layer
- 143: Piezoelectric layer
- 144: Substrate layer

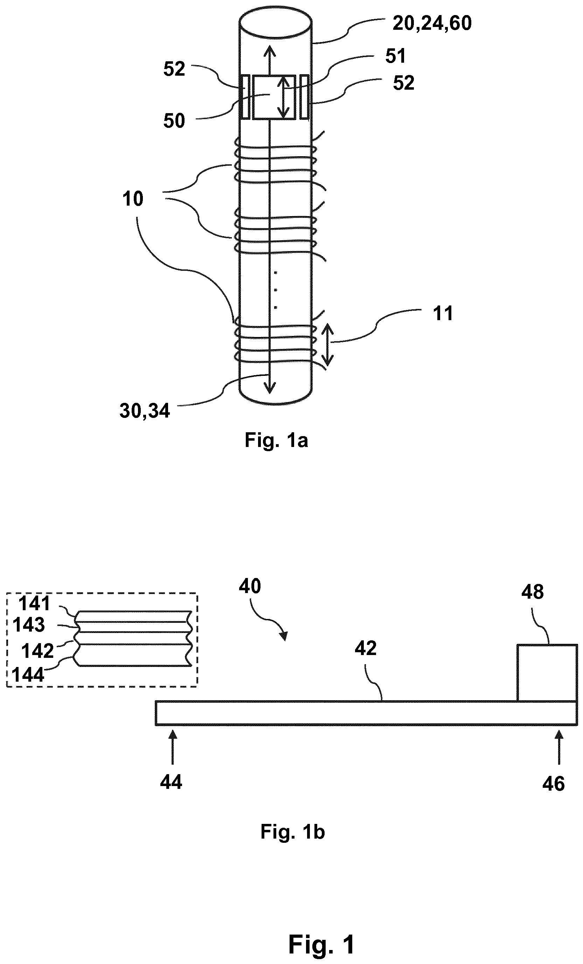

Fig. 1 illustrates one embodiment of the elements of the hybrid energy harvesting unit. Figure 1a illustrates a guiding structure 20 being a linear structure 24 providing a constrained trajectory 30 being a linear trajectory 34. Multiple coils 10 with a coil length 11 is arranged along the guiding structure 20. The three dots along the trajectory line indicate that additional coils 10 may be comprised. Each coil 10 encircles a part of the provided constrained trajectory 30.

In this embodiment, the guiding structure is a tube 60 with the coils being arranged on the exterior face of the tube 60.

A permanent magnet 50 with a permanent magnet length 51 is arranged in the guiding structure 20 and is adapted to move relative to the guiding structure 20 along the provided trajectory 30. A friction reducing suspension 52 for the moveable permanent magnet 50 is comprised in the permanent magnet 50 and/or in the guiding structure 30.

Figure 1b illustrates a piezoelectric element 40 arranged in a cantilever structure 42. The piezoelectric element 40 has an anchoring end 44 and a cantilever tip 46 and comprises a magnetic mass 48 arranged at the cantilever tip 46, here arranged on top of the cantilever structure 42. The insert illustrates an embodiment of the cantilever structure (42) with a substrate layer (144), a bottom electrode layer (142), a piezoelectric layer (143), and a top electrode layer (141). The layers are arranged in a sandwich structure reaching from the anchoring end 44 to the cantilever tip 46.

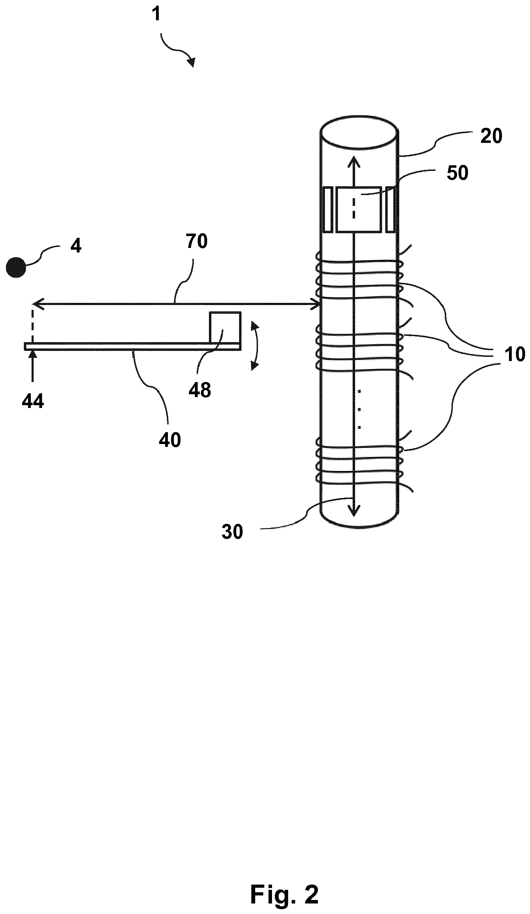

Figure 2 illustrates one embodiment of the arrangement of the elements of the hybrid energy harvesting unit. The elements illustrated in this figure are the same elements as illustrated in figure 1. The hybrid energy harvesting unit is here illustrated as being attached to an object at a point of contact 4. The anchoring end 44 and the guiding structure 20 are fixed relative to the point of contact. Furthermore, the anchoring end 44 and the guiding structure 20 are arranged with a distance 70 between them. This distance should be chosen such that within this distance 70 the permanent magnet 50, when moved relative to a part of the guiding structure 20, interacts with the magnetic mass 48 to deform the piezoelectric element 40.

The deformation of the piezoelectric element 40 may be caused by the permanent magnet 50 passing the magnetic mass 48 when moving along the confined trajectory 30. The deformation may be due to magnetic interaction and when the permanent magnet 50 increases its distance to the magnetic mass 48, the piezoelectric element 40, due to its cantilever structure, will begin to oscillate as indicated by the arched arrow. The hybrid energy harvesting unit 1 harvests energy when the piezoelectric element 40 deforms and when the permanent magnet 50 passes through the coils 10.

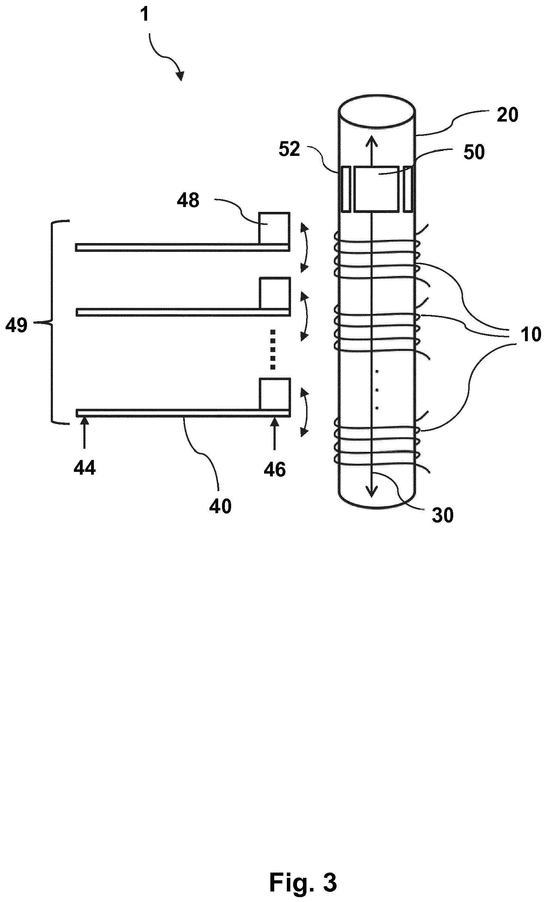

Figure 3 illustrates one embodiment of the hybrid energy harvesting unit 1 with an array 49 of piezoelectric elements 40. The elements illustrated in this figure are the same elements as illustrated in figure 1, but with multiple piezoelectric elements 40.

The operation is similar to that described for the embodiment in figure 2. The anchoring ends 44 and the guiding structure 20 are arranged with a distance between them. This distance should be chosen such that the permanent magnet 50, when moved relative to a part of the guiding structure 20, interacts with the magnetic masses 48 to deform the piezoelectric element 40.

Deformation of the piezoelectric elements 40 may be caused by the permanent magnet 50 passing the magnetic mass 48 when moving along the confined trajectory 30. The deformation may be due to magnetic interaction and when the permanent magnet 50 increases its distance to the magnetic mass 48, each of the piezoelectric elements 40, due to their cantilever structure, will begin to oscillate as indicated by the arrows. The hybrid energy harvesting unit 1 harvests energy, when each of the piezoelectric elements 40 deforms and when the permanent magnet 50 passes through the coils 10.

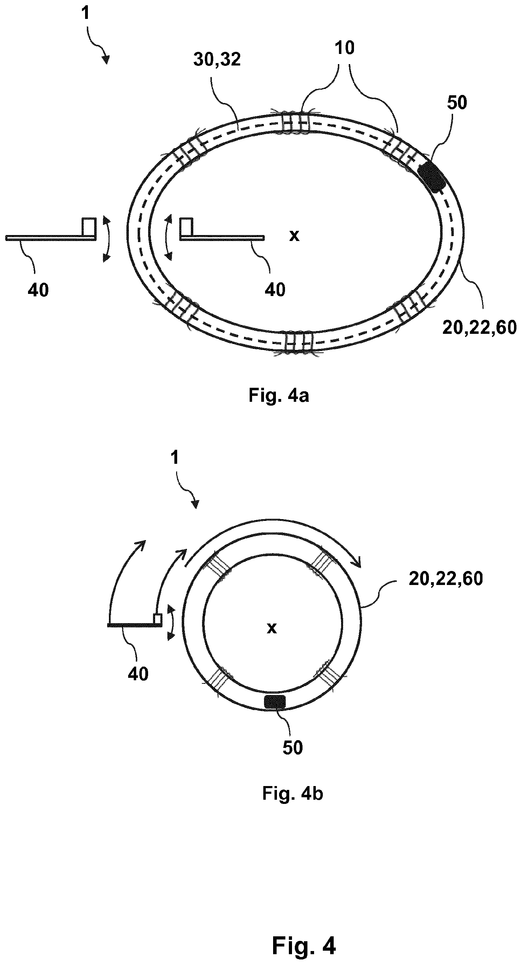

Figure 4 illustrates two embodiments of the hybrid energy harvesting unit 1 with a circular guiding structure 22. Figure 4a illustrates an elongated circular guiding structure 20 comprised of a tube 60 providing a confined circular trajectory 30, 32. In the illustrated embodiment two piezoelectric elements 40 are arranged, one on either side of the guiding structure 20. When the permanent magnet 50 moves along the trajectory 30, it is moved through the coils 10 and past the piezoelectric elements 40.

Figure 4b illustrates a circular guiding structure 20 comprised of a tube 60 providing a confined circular trajectory. In the illustrated embodiment one piezoelectric element 40 is arranged on the outer side of the guiding structure 20. When the permanent magnet 50 moves along the trajectory, it is moved through the coils and passes the piezoelectric element 40.

Hence, the operation as such of the two embodiments in figure 4 is similar to that described for the embodiments in figure 2 and figure 3. However, the hybrid energy harvesting unit 1 with a circular guiding structure 22 providing a trajectory without endpoints may be especially useful for rotational moving objects and for operation with the centre point of rotation arranged in the centre of the circular guiding structure, illustrated with an 'x' in figures 4a and 4b. In such cases, the permanent magnet 50, as illustrated in figure 4b, will be held in an almost static position at the lowest point of the guiding structure due to the gravitational force acting hereon. The guiding structure 20 and the piezoelectric elements 40 will be rotated with the object to which they are attached, as indicated in figure 4b by the arrows.

As the magnetic mass of the piezoelectric elements 40 passes the permanent magnet, a deformation due to magnetic interaction and the cantilever structure may occur with a subsequent oscillation of the piezoelectric element 40, as indicated by the arrows. The hybrid energy harvesting unit 1 harvests energy, when each of the piezoelectric elements 40 deforms and when the coils pass the permanent magnet 50.

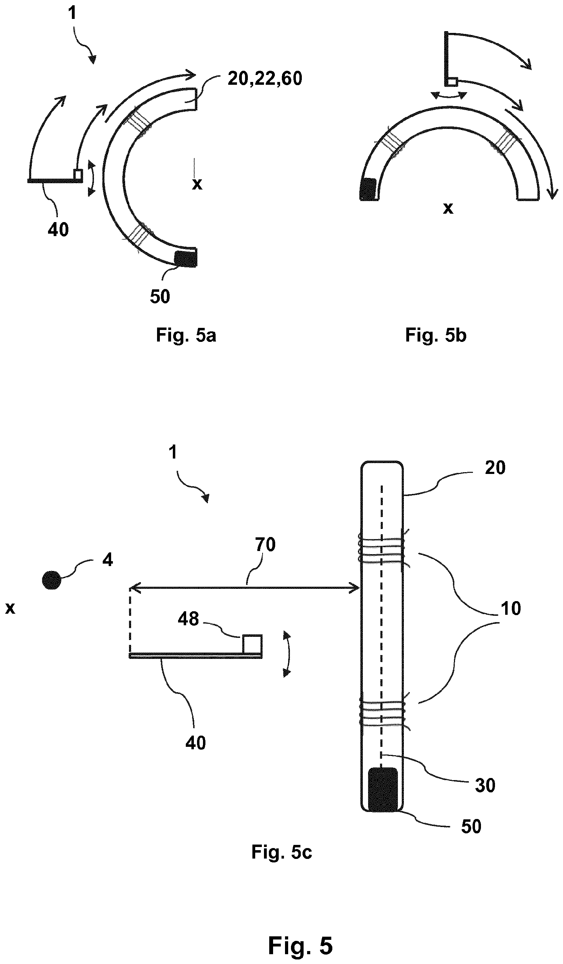

Figure 5 illustrates two embodiments of the hybrid energy harvesting unit 1. Figure 5a and 5b illustrate a half-circular guiding structure 20,22 formed as a tube 60. Here, the confined trajectory for the permanent magnet 50 has two endpoints similar to the linear trajectory illustrated in the embodiments in figure 5c.

This hybrid energy harvesting unit 1 may be usefully operated attached to rotational moving objects and for operation with the centre point of rotation arranged in the centre of the circular guiding structure, illustrated with an 'x'. In this case of operation, the closed end of the guiding structure will, as illustrated in the shift in position from figure 5a to figure 5b, move the permanent magnet 50 in a circular motion until the trajectory and the gravitational force is aligned such that the permanent magnet may fall along the trajectory to the other end of the guiding structure or, alternatively, to the lowest part of the guiding structure. There, in the lowest part of the guiding structure, the permanent magnet may be held in a static position while the guiding structure, the coils, and the piezoelectric element 40 pass until the closed end of the guiding structure reaches the permanent magnet 50 and again move the permanent magnet 50 in a circular motion.

An alternative operation of a half-circular guiding structure could be advantageous in regard to an object which has a rocking motion which may include tilting, rolling or similar movements. Operated as such, the guiding structure may be operated in a position opposite to that illustrated in figure 5b such that the permanent magnet 50 will be held in an almost static position at the lowest point of the guiding structure due to the gravitational force acting hereon. The position of the guiding structure 20 and the piezoelectric elements 40 will be shifted in a rocking motion rotated with the object to which they are attached such that the coils and piezoelectric element 40 will repeatedly pass the permanent magnet 50.

Figure 5c illustrates an embodiment of a hybrid energy harvesting unit with a linear guiding structure 20 similar to the embodiment illustrated in figure 2. The hybrid energy harvesting unit 1 is here illustrated as being attached to an object at a point of contact 4. The anchoring end 44 and the guiding structure 20 are fixed relative to the point of contact. Furthermore, the anchoring end 44 and the guiding structure 20 are arranged with a distance 70 between them. This distance should be chosen such that, within this distance 70, the permanent magnet 50, when moved relative to a part of the guiding structure 20, interacts with the magnetic mass 48 to deform the piezoelectric element 40.

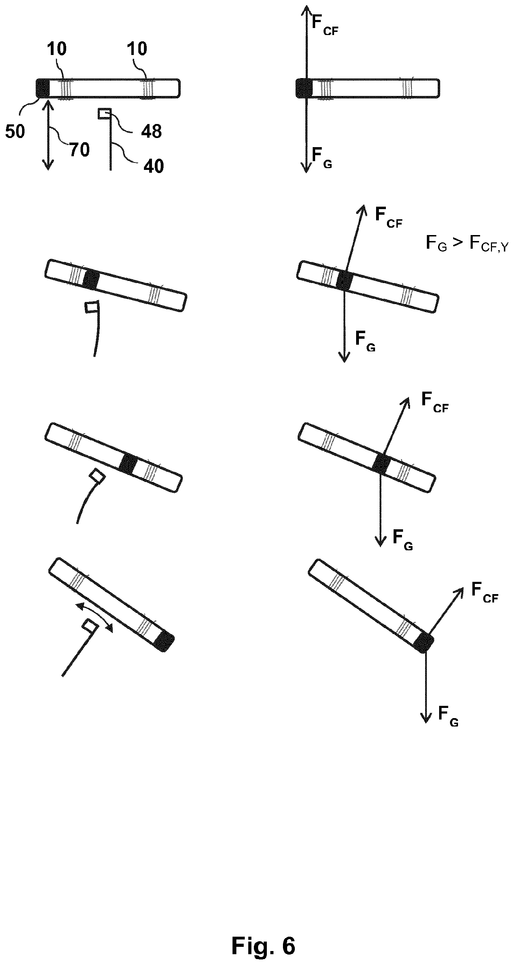

Figure 6 illustrates one way of operating the hybrid energy harvesting unit 1 illustrated in figure 5c. The figures on the left hand side illustrate the interaction between the permanent magnet 50 and the piezoelectric element 40 as the position of the hybrid energy harvesting unit 1 is changed due to a rotational motion with a rotational centre 'x' as indicated in figure 5c. On the right hand side, the forces acting on the permanent magnet are illustrated by F_CF and F_G being the vector representation. When the gravitational force F_G exceeds the Y-component of the centrifugal forces F_CF the permanent magnet 50 begins to move along the confined trajectory to the lowest part of the guiding structure, here a closed end of the guiding structure. In this case any frictional resistance or other sources of interacting forces are neglected.

The permanent magnet 50 and the magnetic mass 48 of the piezoelectric element 40 in the illustrated embodiment are oppositely poled to attract each other. Hence, the piezoelectric element 40 is deformed towards the permanent magnet 50 as it passes, and when the distance increases and the magnetic interaction decreases below that of the 'spring force' of the piezoelectric element 40, the piezoelectric element 40 begins to oscillate.

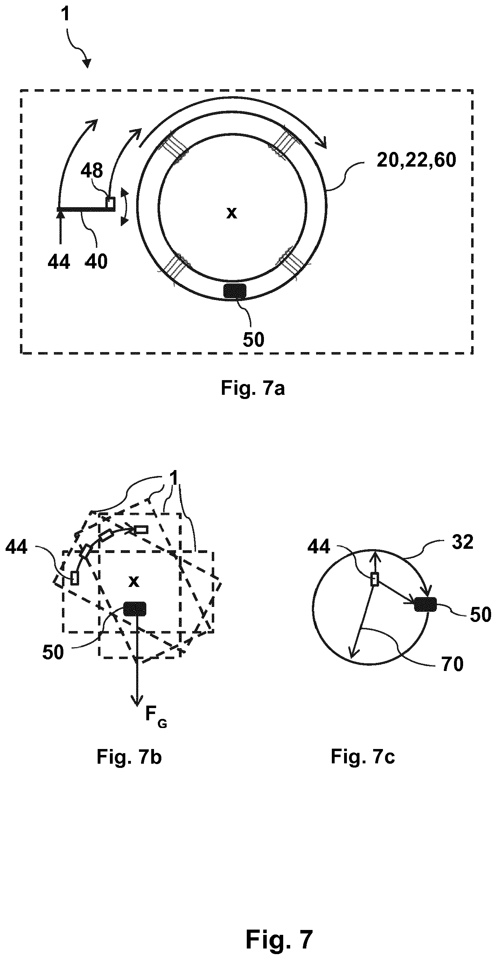

Figure 7 illustrates one way of operating the hybrid energy harvesting unit 1 illustrated in figure 4b as also illustrated in figure 7a. Figures 7b and 7c illustrate how the distance 70 between the anchoring end 44 of the piezoelectric element 40 and the permanent magnet 50 changes as the hybrid energy harvesting unit 1 is rotated with the object, to which it is attached, around the rotational centre indicated by the 'x' in figures 7a and 7b. The dotted box in figure 7b illustrates the rotation of the hybrid energy harvesting unit 1 of figure 7a. The illustrated operation results in a trajectory of the permanent magnet 50 relative to the piezoelectric elements anchoring which may be perceived as a confined trajectory 32.

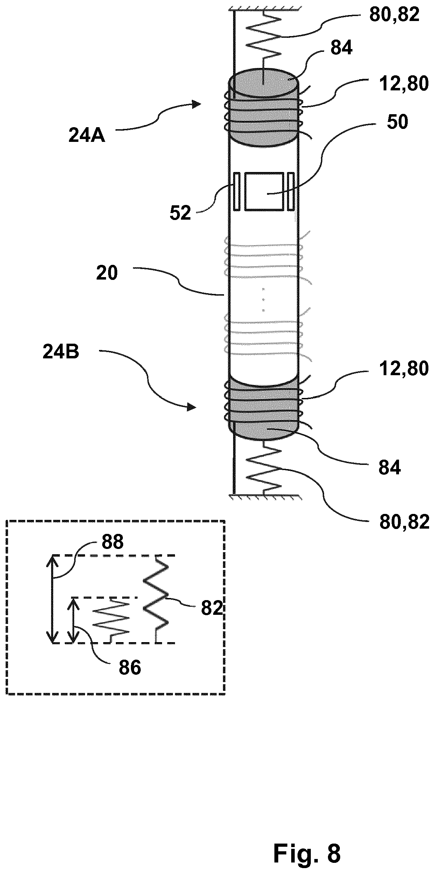

Figure 8 illustrates an embodiment of the hybrid energy harvesting unit 1 with suspension arrangements 80. The hybrid energy harvesting unit 1 comprises a linear guiding structure 20 comprising a permanent magnet 50 and friction reducing suspension 52. The guiding structure comprises a first closed end 24A and a second closed end 24B. Furthermore, a stopper permanent magnet 84 is arranged in connection with either of the closed ends 24A, 24B.

The embodiment comprises a suspension arrangement 80 in either of the closed ends 24A, 24B. The suspension arrangements 80 each comprises a fixed coil 12 and a deformable suspension 82 having a compressed length 86 and an elongated length 88, as illustrated in the insert lower left corner of figure 8. The suspension arrangement 80 is arranged with one end of the deformable suspension 82 and one end of the fixed coil 12 fixed to the object 2 (illustrated with 'ground'), and with the fixed coil 12 encircling the stopper permanent magnet 84 or a part hereof.

If the guiding structure is set in motion, it will oscillate between the fastening points, and the stopper permanent magnet 84 will move back and forth through the fixed coil 12.

In this embodiment the deformable suspension is illustrated as a spring.

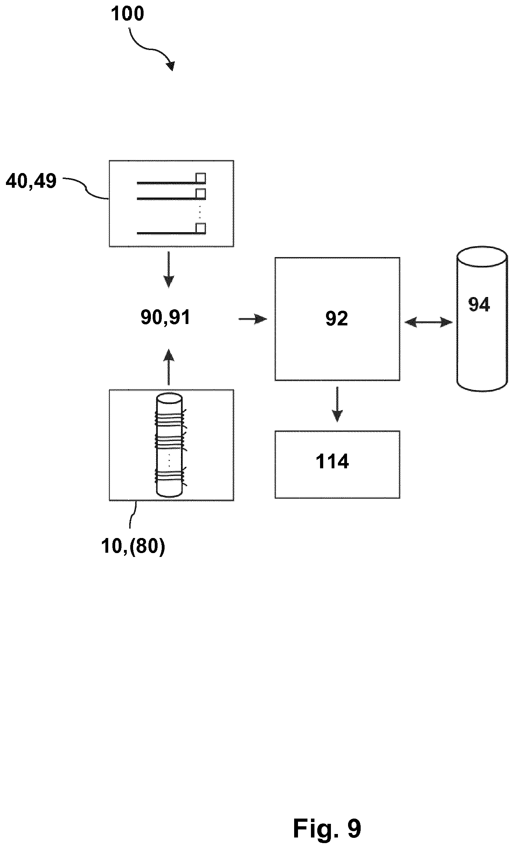

Figure 9 illustrates the use 100 of the hybrid energy harvesting unit with an array 49 of piezoelectric elements 40 with a power consuming unit 114. The elements of the hybrid energy harvesting unit, including the array 49 of piezoelectric elements 40, the coils 10, and possible the suspension arrangement 80, are connected to an interconnecting circuit 91 and a rectifier circuit 90. A power management circuit 92 distributes the electric power between the power consuming unit 114 and rechargeable energy storage 94.

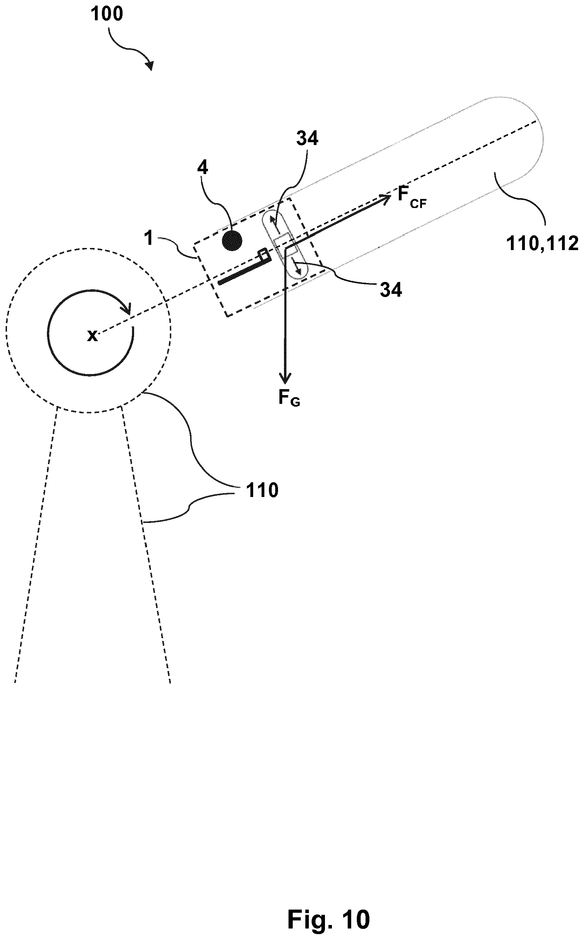

Figure 10 illustrates the use 100 of the hybrid energy harvesting unit 1 attached to an object in motion at a point of contact 4. Here, the object is a wind turbine blade being a rotationally moveable part (112) comprised in a wind turbine (110). The centre of rotation of the wind turbine and the attached hybrid energy harvesting unit 1 are illustrated by the 'x'.

The hybrid energy harvesting unit 1 can be located inside or outside on the blade or built into the structure of the blade.

The illustrated wind turbine 110, including the rotor and the blade, is for illustrative purposes and is in a simple schematic outline. The dimension of the wind turbine 110 and the hybrid energy harvesting unit 1 is illustrated in non-comparable dimensions.

The hybrid energy harvesting unit 1 comprises a piezoelectric element and a linear guiding structure with a constrained linear trajectory 34. The permanent magnet in the guiding structure moves along the linear trajectory 34.

When the blade rotates both the gravitational force, f_G, and the centrifugal force, f_CF, act on the permanent magnet. The forces are illustrated by F_CF and F_G being the vector representation. When the gravitational force, F_G, exceeds the Y-component of the centrifugal forces, F_CF, the permanent magnet begins to move along the confined trajectory to the lowest part of the guiding structure, here a closed end of the guiding structure.

In this case, for illustrative purposes, any frictional resistance or other sources of interacting forces are neglected, just as the opposing force of the wall of the guiding structure is not illustrated.

## Claims

1. Hybrid energy harvesting unit (1) configured to harvest energy when being attached to an object (2) in motion at a point of contact (4), the hybrid energy harvesting unit (1) comprising:
- one or more coils (10) with a coil length (11) arranged along a guiding structure (20) adapted to provide a constrained trajectory (30), each coil (10) encircling a part of the provided constrained trajectory (30);
- a piezoelectric element (40) arranged in a cantilever structure (42) with an anchoring end (44) and a cantilever tip (46) and comprising a magnetic mass (48) arranged at the cantilever tip (46), and
- a permanent magnet (50) with a permanent magnet length (51) arranged in the guiding structure (20) and adapted to move relative to the guiding structure (20),
the anchoring end (44) and the guiding structure (20) being adapted to be attached to the object (2) separated by a distance (70), within which distance (70) the permanent magnet (50), when moved relative to a part of the guiding structure (20), interacts with the magnetic mass (48) to deform the piezoelectric element (40).

2. A hybrid energy harvesting unit (1) according to claim 1, wherein the one or more coils (10) arranged along one guiding structure (20) have coil lengths (11) which are substantially equal to the permanent magnet length (51) of the permanent magnet (50) comprised in the guiding structure (20).

3. A hybrid energy harvesting unit (1) according to any one or more of the preceding claims, wherein the permanent magnet (50) has a magnetic field being higher or equal to the magnetic field of the one or more magnetic masses (48) it interacts with.

4. A hybrid energy harvesting unit (1) according to any one or more of the preceding claims, where the permanent magnet (50) and/or the guiding structure (30) comprise(s) friction reducing suspension (52) for the moveable permanent magnet (50).

5. A hybrid energy harvesting unit (1) according to any one or more of the preceding claims, wherein the cantilever structure (42) of the piezoelectric element (40) comprises a substrate layer (144), a bottom electrode layer (142), a piezoelectric layer (143), and a top electrode layer (141), the layers being arranged in a sandwich structure reaching from the anchoring end 44 to the cantilever tip 46 and with the piezoelectric layer (143) arranged between the top electrode layer (141) and the bottom electrode layer (142).

6. A hybrid energy harvesting unit (1) according to any one or more of the preceding claims, comprising multiple piezoelectric elements (40) in an array (49), with the anchoring end (44) of each piezoelectric element (40) being adapted to be attached to the object (2) at a distance (70) within which distance (70) the permanent magnet (50), when moved relative to a part of the guiding structure (20), interacts with the magnetic mass (48) to deform the piezoelectric element (40).

7. A hybrid energy harvesting unit (1) according to any one or more of the preceding claims, wherein the guiding structure comprises a first closed end (24A) and a second closed end (24B) and further comprises a stopper permanent magnet (84) in one or both closed ends (24A,24B).

8. A hybrid energy harvesting unit (1) according to claim 7, comprising a stopper permanent magnet (84) and further comprising a suspension arrangement (80) in either closed end (24A, 24B), the suspension arrangement comprising a fixed coil (12) and a deformable suspension (82) having a compressed length (86) and an elongated length (88) and being adapted to be arranged with one end of the deformable suspension (82) and one end of the fixed coil (12) fixed to the object (2), and with the fixed coil (12) adapted to be arranged to encircle the stopper permanent magnet (84) or a part hereof at a length of the deformable suspension (82) being within the range between the compressed length (86) and the elongated length (88).

9. A hybrid energy harvesting unit (1) according to any one or more of the preceding claims, comprising an interconnecting circuit (91) and a rectifier circuit (90).

10. A hybrid energy harvesting unit (1) according to any one or more of the preceding claims, comprising a power management circuit (92) and rechargeable energy storage (94).

11. Method (200) for harvesting energy from an object (2) in motion comprising the acts of:
- displacing (210) a permanent magnet (50) through one or more coils along a guiding structure (20), and
- arranging (220) a piezoelectric element (40) with a cantilever structure (42), an anchoring end (44) and a cantilever tip (46) with a magnetic mass (48) with a distance (70) to the guiding structure (20), within which distance (70) the permanent magnet (50), when moved relative to at a part of the guiding structure (20), interacts with the magnetic mass (48) to deform the piezoelectric element (40).

12. Use (100) of the hybrid energy harvesting unit (1) according to any one or more of the preceding claims 1-10 attached to a rotational moveable part (112).

13. Use (100) of the hybrid energy harvesting unit (1) according to claim 12, wherein the rotational moveable part (112) is comprised in a wind turbine (110).

14. Use (100) of the hybrid energy harvesting unit (1) according to any one or more of the preceding claims 1-10 embedded in a power consuming unit (114).
